# EUROPEAN PATENT SPECIFICATION

(11) **EP 1 001 460 B1**
(45) Date of publication and mention of the grant of the patent: **02.05.2001**
(21) Application number: 98119508.4
(22) Date of filing: 15.10.1998
(51) Int. Cl.: H01L 21/66

(54) **Method and apparatus for detecting, monitoring and characterizing edge defects on semiconductor wafers**
Verfahren und Vorrichtung zum Detektieren, Überwachung und Charakterisierung von Kantendefekten in Halbleiterscheiben
Procédé et appareil pour détecter, surveiller et caractériser des défauts de bordure sur les plaquettes semiconductrices

(43) Date of publication of application: 17.05.2000
(73) Proprietor: Wacker Siltronic Gesellschaft für Halbleitermaterialien Aktiengesellschaft, 84489 Burghausen (DE)
(72) Inventor: Nicolesco, Claudian Dr., Portland, Oregon 97236 (US)
(74) Representative: Rimböck, Karl-Heinz, Dr.

(56) References cited:
- EP-A- 0 100 446
- EP-A- 0 120 211
- EP-A- 0 468 817
- EP-A- 0 742 587
- EP-A- 0 766 298

## Description

It is well known that edge crown, bevels and near-to-edge wafer defects, such as scratches, grooves, cracks and chips can dramatically reduce the performance of ULSI structures in electronic devices.

The visual, non-contact inspection of the edge, all-around the wafer, at different stages of wafer processing, such as slicing, lapping, edge-shaping, grinding, etching, and polishing is generally performed by trained operators, under a bright light, with a naked eye or with a magnifier lens.

The submillimetric size of the majority of edge defects makes the visual inspection with a naked eye almost inefficient. Using a classic optical microscope, with a 10X to 100X magnification can be an alternative but these microscopes generally miss large diameter wafer edge inspection stages and the necessary available room to install these stages under their objective.

A better alternative to these methods it was the inspection with a video camera microscope. Most edge inspection equipment currently available uses video camera with microscope attached, and visible fluorescent lamps, or red laser as light sources, for detecting, monitoring and characterizing the edge defects.

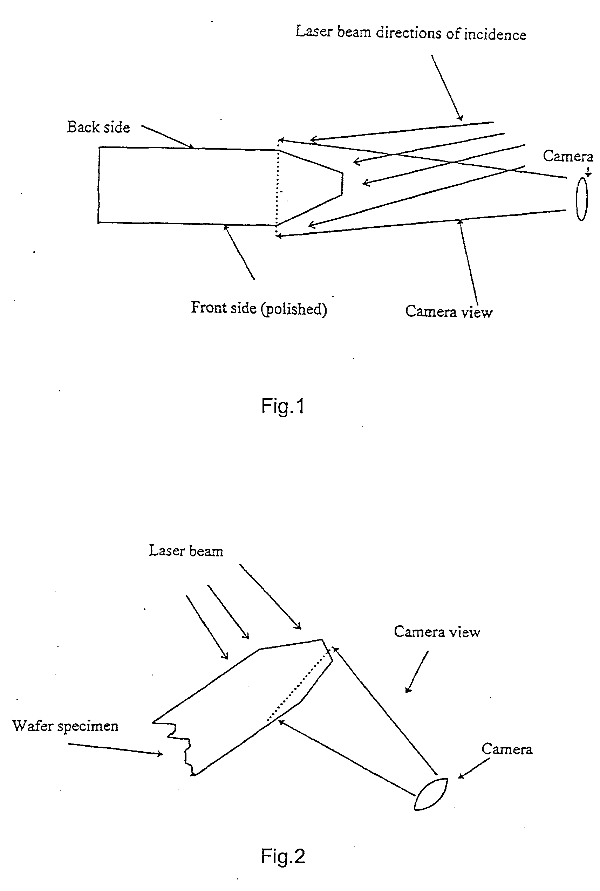

Basically for these instruments, the reflected light that contains information about the edge defects is captured by the video camera and displayed on a TV monitor. The light source and the video camera are always on the same side of the inspected edge, as shown in Fig.1 representing a so-called reflective configuration (R-configuration), and the light source spectrum is always in the visible domain (400 to 700 nm).

EP-766 298 A2 discloses a method and an apparatus for determining residual crystal damages caused to wafer edges by an optical-acoustical process. EP-468 817 A2 concerns an infrared scanning microscope and a method of assessing a polished surface of a semiconductor specimen using the infrared scanning microscope. EP-100 446 A1 refers to a high resolution automatic imaging and inspecting system for shape dimensional inspection and for defect detection on edges of small articles. EP-120 211 A2 is related to a method and an apparatus for the dimensional checking of solid bodies with a laser beam.

It is the object of the present invention to overcome limitations of known equipment with respect to edge defects detection performance.

The above object is achieved according to the present invention by a method for detecting, monitoring and characterizing edge defects on semiconductor wafers, comprising illuminating the edge of a wafer with an infrared laser beam, the wafer being tilted with respect to the laser beam; and inspecting the illuminated wafer edge with at least one infrared video camera.

The above object is further achieved according to the present invention by an apparatus for detecting, monitoring and characterizing edge defects on semiconductor wafers comprising an infrared illumination system illuminating the wafer edge with an infrared laser beam; a tiltable platform presenting the wafer in a tilted manner with respect to the infrared laser beam; and at least one infrared video camera monitoring the illuminated wafer edge.

The reflected light intensity emerging from a specimen, e.g. a silicon wafer edge, may be influenced by any combination of light absorption, scattering, diffraction and distortion. Light scattered by particles and crystalline defects on the edge may have a negative image distortion impact on the specular reflected energy which contains edge defect shape information. At the same time, light absorption may be significant under the same conditions; as deep the incident laser beam enters the edge surface, as much defect information is obtained. In both cases, the size, scattering and absorptive characteristics of the semiconductor material defect or edge contaminant play a combined role in the reflected image.

In order to get a better edge defect visualization an infrared laser illumination source for illuminating the wafer edge and an infrared sensitive camera for monitoring wafer edge defects is used. It is particularly preferred to illuminate the wafer edge with a multi-wavelangth laser, e.g. a Yag-Nd green laser, with a three wavelength laser beam, two of them in the near-infrared domain (806 nm and 1064 nm), and one in the green range (532 nm). Using a filter wheel, one, two or all three of these wavelength combination may be selected when inspecting the wafer edge. This laser feature increases the edge defects visualization. An infrared sensitive CCD video camera will be used for inspection.

Further contributions of the invention are related to the geometric configuration used for inspecting the wafer edge. These contributions are further discussed with reference to figures which schematically show essential features of wafer edge inspection devices according to the invention.
Fig.2 shows a preferred configuration for wafer edge inspection.
Fig.3 shows further preferred configuration for wafer edge inspection.
Fig.4 shows still another preferred configuration for wafer edge inspection.
Fig.5 shows an apparatus for wafer edge inspection that was designed in accordance with the configuration referred to in fig.4.
Fig.6 shows the principle of the sliding deflector system referred to in fig.5.
Fig.7 shows an alternative deflector system to the system referred to in fig.6

It was found that the wafer angular position plays an important role in the edge and bevel inspection. A wafer tilt angle of preferable 30 to 45 degrees from horizontal, allows a better view of the bevel and an uniform illumination of it and the detection of bevel-near-to-surface microchips and microcracks, responsible for epitaxial-layers-defects.

The apparatus configuration according to Fig.2 is particularly suitable for detecting edge cracks that pass from one edge side to the other side. In this so-called infrared laser beam transmissive configuration (T-configuration) the laser beam impinges the specimen from the opposite side, and the infrared rays that pass through the cracks are visible as second sources of light by the camera. Using the transmissive configuration is then possible to isolate the microcracks, that almost likely generate wafer breakage, from larger category of edge chips and grinding wheel grooves defects.

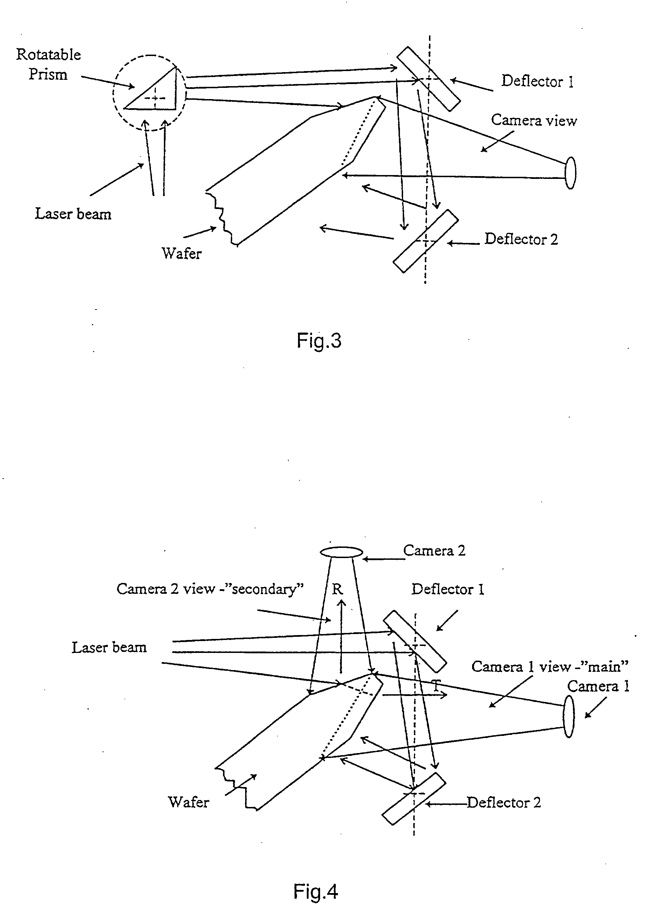

According to the configuration depicted in Fig.3. both inspection configurations, the reflective and the transmissive configuration are implemented with a unique configuration (one camera R/T-configuration). This configuration further comprises two diffusive, rotatable deflectors, which create an uniform laser beam illumination area by the inspected wafer edge, and a rotatable prism, which allows to target the edge and the deflectors, simultaneously. The one-camera R/T configuration is able to facilitate a complete view of the edge and its front side bevel, facing the camera. The camera view covers more than half of the entire wafer's edge area.

The remaining part of the edge becomes visible if a second camera is added. Fig.4 shows this two-camera R/T configuration. According to this configuration two distinct cameras are provided, camera 1 covering more than half of the entire edge, plus a small sector of the front surface, and a second camera 2, covering the remaining edge half. The information provided by camera 1, facing edge and bevel, will contain information resulted both by reflection, scattering and diffusion of the laser beam, and by transmission of the same laser beam through the edge cracks, from the backside to the front side of the wafer. The information provided by camera 2 will contain information resulted by reflection, scattering and diffusion of the laser beam.

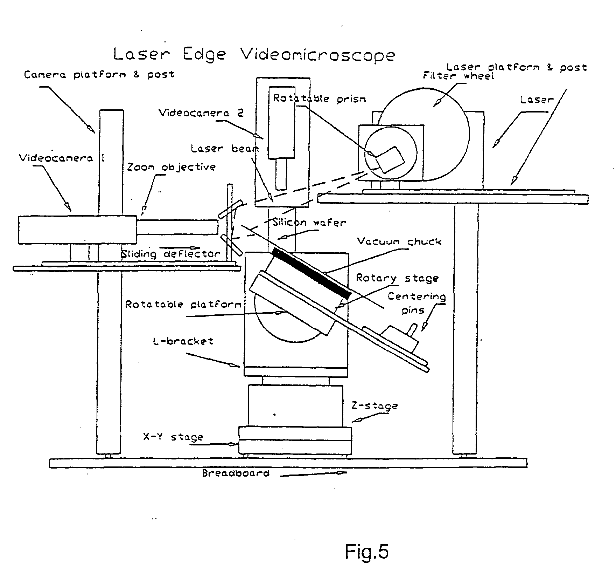

Fig.5 represents a wafer edge inspecting apparatus, which is constructed in accordance with the two-camera R/T configuration. The whole system is supported by an optical breadboard of 300x600 mm. The video camera 1, the zoom microscope objective, and the laser beam deflectors are mounted breadboard of 300×600 mm. The video camera 1, the zoom microscope objective, and the laser beam deflectors are mounted on sliding carriers, on optic mini rails, installed on a horizontal rotatable platform and rod clamp, which may be lifted on an optic rod.

The laser source can be lifted on a second optic rod, with a rotatable platform and rod clamp too. The laser beam will be directed toward the beam deflector/diffuser using a rotatable prism. The wafer chuck is installed on a rotary stage, placed on a rotatable (0 to 45°) platform, on a corner bracket, which is supported by the z and x,y-translation stages. A sliding carrier with Teflon® removable pins, which can slide on a tilted mini rail is suitable for centering the wafer on the Teflon^{®}-coated vacuum chuck.

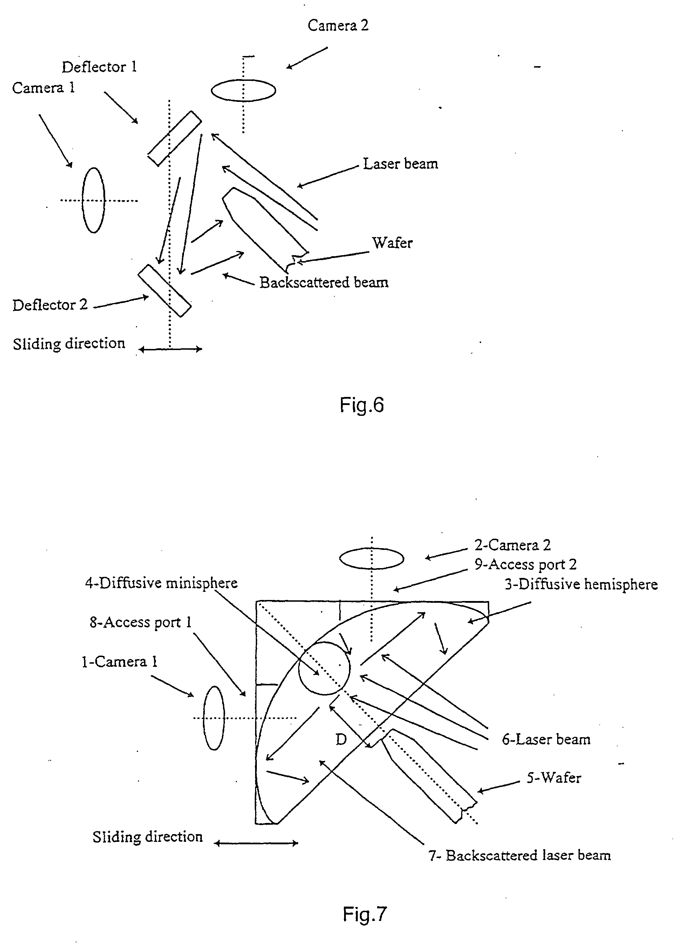

Fig. 6 shows the principle of the sliding deflector system for a uniform laser illumination and improved crack detection which is used in the apparatus according to Fig.5. This deflector system comprises a sliding deflector, composed of two rotatable deflectors/diffusers.

The deflector system shown in fig.6 can be replaced by a continuous diffusive hemisphere system as represented in Fig.7. This system comprises a diffusive hemisphere, that has two camera access ports for collecting the wafer edge images with two cameras, and a centered diffusive minisphere placed at equal distances from the access ports. Sliding the hemisphere changes the distance D between the minisphere and the wafer's edge.

The laser beam impinges upon the diffusive minisphere and is uniformly reflected toward the hemisphere and the wafer. The laser can be focused on the minisphere, can be moved on it by rotating prism shown in Fig.5, or can be defocused, changing its cross-section in contact with the minisphere.

By sliding the hemisphere, or moving the laser spot on the hemisphere, or by defocusing the laser beam, the illumination pattern emerging from the hemisphere can be continuously changed from a brightfield source to an uniform diffuse, darkfield/brightfield-shadowfree light source, or even to a directionally darkfield only.

## Claims

1. Method for detecting, monitoring and characterizing edge defects on semiconductor wafers, comprising illuminating the edge of a wafer with an infrared laser beam, the wafer being tilted with respect to the laser beam; and inspecting the illuminated wafer edge with at least one infrared video camera.

2. Method according to claim 1, comprising tilting the wafer with respect to the laser beam by an angle of 30 to 45 degrees.

3. Method according to claim 1 or claim 2, wherein the wafer edge is illuminated with a three wavelength infrared laser.

4. Method according to one of claims 1 to 3, wherein the laser illuminating the edge of the wafer and the video camera are arranged in a transmissive configuration.

5. Method according to one of claims 1 to 4, wherein the laser illuminating the edge of the wafer and the video camera are arranged in a combined reflective and transmissive configuration.

6. Apparatus for detecting, monitoring and characterizing edge defects on semiconductor wafers comprising an infrared illumination system illuminating the wafer edge with an infrared laser beam; a tiltable platform presenting the wafer in a tilted manner with respect to the infrared laser beam; and at least one infrared video camera monitoring the illuminated wafer edge.

7. The apparatus according to claim 6, wherein the infrared illumination system is a three wavelength infrared laser beam illumination system.

8. The apparatus according to claim 6 or claim 7, further comprising a sliding deflector system composed of two rotatable deflectors/diffusers which create an uniform laser beam illumination area by the inspected wafer edge.

9. The apparatus according to claim 6 or claim 7, further comprising a deflector system composed of a continuous diffusive hemisphere, and a diffusive minisphere for producing a specific changeable illumination pattern emerging from the hemisphere.

10. Apparatus according to one of claims 6 to 9, wherein the illumination system comprises two of said infrared video cameras, and the wafer and the two said infrared video cameras are arranged in both a reflection and transmission configuration.

## Patentansprüche

1. Verfahren für die Erfassung, Überwachung und Kennzeichnung von Kantendefekten an Halbleiterwafern, das das Beleuchten der Kante eines Wafer mit einem Infrarotlaserstrahl, wobei der Wafer bezüglich des Laserstrahls geneigt ist; und das Untersuchen der beleuchteten Waferkante mit mindestens einer Infrarotvideokamera umfaßt.

2. Verfahren nach Anspruch 1, das umfaßt, den Wafer in Bezug auf den Laserstrahl um einen Winkel von 30 bis 45 Grad zu neigen.

3. Verfahren nach Anspruch 1 oder 2, bei dem die Waferkante mit einem Drei-Wellenlängen-Infrarotlaser beleuchtet wird.

4. Verfahren nach einem der Ansprüche 1 bis 3, bei dem der die Kante des Wafer beleuchtende Laser und die Videokamera in einer Transmissionskonfiguration angeordnet sind.

5. Verfahren nach einem der Ansprüche 1 bis 4, bei dem der die Kante des Wafer beleuchtende Laser und die Videokamera in einer kombinierten Reflexions- und Transmissionskonfiguration angeordnet sind.

6. Vorrichtung für die Erfassung, Überwachung und Kennzeichnung von Kantendefekten an Halbleiterwafern, die folgendes umfaßt: ein Infrarotbeleuchtungssystem, das die Waferkante mit einem Infrarotlaserstrahl beleuchtet; eine neigbare Plattform, die den Wafer bezüglich des Infrarotlaserstrahls geneigt hält; und mindestens eine Infrarotvideokamera, die die beleuchtete Waferkante überwacht.

7. Vorrichtung nach Anspruch 6, bei der das Infrarotbeleuchtungssystem ein Drei-Wellenlängen-Infrarotlaserstrahl-Beleuchtungsystem ist.

8. Vorrichtung nach Anspruch 6 oder 7, weiterhin mit einem gleitenden Deflektorsystem, das aus zwei drehbaren Deflektoren/Diffusoren besteht, die eine gleichförmige Laserstrahlbeleuchtungsfläche durch die untersuchte Waferkante erzeugen.

9. Vorrichtung nach Anspruch 6 oder 7, weiterhin mit einem Deflektorsystem, das aus einer kontinuierlichen diffundierenden Halbkugel und einer diffundierenden Minikugel zum Erzeugen eines aus der Halbkugel austretenden spezifischen veränderbaren Beleuchtungsmuster besteht.

10. Vorrichtung nach einem der Ansprüche 6 bis 9, bei der das Beleuchtungssystemen zwei der Infrarotvideokameras umfaßt und der Wafer und die beiden Infrarotvideokameras sowohl in einer Reflexions- als auch Transmissionskonfiguration angeordnet sind.

## Revendications

1. Procédé pour détecter, surveiller et caractériser les défauts de bordure sur des plaquettes semiconductrices, comprenant l'illumination de la bordure d'une plaquette à l'aide d'un faisceau laser infrarouge, la plaquette étant inclinée par rapport au faisceau laser ; et l'inspection de la bordure de la plaquette illuminée à l'aide d'au moins une caméra vidéo infrarouge.

2. Procédé selon la revendication 1, comprenant l'inclinaison de la plaquette par rapport au faisceau laser d'un angle de 30 à 45 degrés.

3. Procédé selon la revendication 1 ou la revendication 2, dans lequel la bordure de la plaquette est illuminée à l'aide d'un laser infrarouge à trois longueurs d'onde.

4. Procédé selon l'une quelconque des revendications 1 à 3, dans lequel le laser illuminant la bordure de la plaquette et la caméra vidéo sont agencés suivant une configuration transmissive.

5. Procédé selon l'une quelconque des revendications 1 à 4, dans lequel le laser illuminant la bordure de la plaquette et la caméra vidéo sont agencés suivant une configuration de réflexion et de transmission combinée.

6. Appareil pour détecter, surveiller et caractériser les défauts de bordure sur des plaquettes semiconductrices comprenant un système d'illumination infrarouge illuminant la bordure d'une plaquette à l'aide d'un faisceau laser infrarouge ; une plate-forme inclinable présentant la plaquette d'une manière inclinée par rapport au faisceau laser infrarouge ; et au moins une caméra vidéo infrarouge surveillant la bordure de la plaquette illuminée.

7. Appareil selon la revendication 6, dans lequel le système d'illumination infrarouge est un système d'illumination à faisceau laser infrarouge à trois longueurs d'onde.

8. Appareil selon la revendication 6 ou la revendication 7, comprenant en outre un système déflecteur coulissant composé de deux déflecteurs / diffuseurs rotatifs qui créent une zone d'illumination uniforme du faisceau laser par la bordure de la plaquette inspectée.

9. Appareil selon la revendication 6 ou la revendication 7, comprenant en outre un système déflecteur composé d'un hémisphère diffuseur continu et d'une minisphère diffuseuse pour produire un motif d'illumination variable spécifique émergeant de l'hémisphère.

10. Appareil selon l'une des revendications 6 à 9, dans lequel le système d'illumination comprend deux desdites caméras vidéo infrarouge, et la plaquette et les deux desdites caméras vidéo infrarouge sont agencées suivant une configuration à la fois de réflexion et de transmission.
